(19) Europäisches Patentamt
European Patent Office
Office européen des brevets

(11) EP 3 611 208 B1

(12) **EUROPEAN PATENT SPECIFICATION**

(45) Date of publication and mention of the grant of the patent:
**04.11.2020 Bulletin 2020/45**

(21) Application number: **18783832.1**

(22) Date of filing: **09.04.2018**

(51) Int Cl.:
***C08G 59/24*** *(2006.01)*
***C08G 59/40*** *(2006.01)*
***C08J 5/24*** *(2006.01)*
***C08L 63/00*** *(2006.01)*
***C08G 59/22*** *(2006.01)*
***B32B 15/08*** *(2006.01)*
***C08G 73/00*** *(2006.01)*
***C08K 3/013*** *(2018.01)*
***H05K 1/03*** *(2006.01)*

(86) International application number:
**PCT/JP2018/014899**

(87) International publication number:
**WO 2018/190292 (18.10.2018 Gazette 2018/42)**

(54) **RESIN COMPOSITION, PREPREG, METAL FOIL-CLAD LAMINATE, RESIN SHEET AND PRINTED WIRING BOARD**

HARZZUSAMMENSETZUNG, PREPREG, METALLFOLIENUMKLEIDETES LAMINAT, HARZFOLIE UND LEITERPLATTE

COMPOSITION DE RÉSINE, PRÉIMPRÉGNÉ, STRATIFIÉ REVÊTU D'UNE FEUILLE MÉTALLIQUE, FEUILLE DE RÉSINE ET CARTE DE CIRCUIT IMPRIMÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.04.2017 JP 2017077757**

(43) Date of publication of application:
**19.02.2020 Bulletin 2020/08**

(73) Proprietor: **Mitsubishi Gas Chemical Company, Inc.**
**Tokyo 100-8324 (JP)**

(72) Inventors:
- **KOGA, Shota**
  **Tokyo 125-8601 (JP)**
- **NAKAZUMI, Yoshihiro**
  **Tokyo 125-8601 (JP)**
- **TAKANO, Kentaro**
  **Tokyo 125-8601 (JP)**

(74) Representative: **Hoffmann Eitle**
**Patent- und Rechtsanwälte PartmbB**
**Arabellastraße 30**
**81925 München (DE)**

(56) References cited:
**WO-A1-2009/123058**
**WO-A1-2010/086932**
**JP-A- H01 306 405**
**JP-A- S59 155 428**
**JP-A- 2011 089 038**
**JP-A- 2011 144 361**
**JP-A- 2012 017 405**
**JP-A- 2013 006 955**
**JP-A- 2016 008 280**
**JP-A- 2017 504 499**
**JP-B2- S5 231 279**
**US-A1- 2015 104 651**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 611 208 B1

## Description

### Technical Field

The present invention relates to a resin composition, a prepreg, a metal foil-clad laminate and a resin sheet using the resin composition or prepreg, and a printed wiring board using these.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, moisture absorption heat resistance, flame retardancy, a low dielectric constant, a low dielectric loss tangent, a low thermal expansion coefficient, heat resistance, chemical resistance, and high plating peel strength. But, these required characteristics have not always been satisfied so far.

Conventionally, as resins for printed wiring boards having excellent heat resistance and electrical characteristics, cyanate compounds are known, and in recent years, resin compositions using cyanate compounds in combination with epoxy resins, bismaleimide compounds, and the like have been widely used for materials for highly functional printed wiring boards such as for semiconductor plastic packages, and the like. In addition, due to smaller size and higher density of multilayer printed wiring boards, a large amount of heat is accumulated in electronic components, and the heat dissipation properties of printed wiring boards are required. Further, the problem of an increase in warpage occurs in multilayer printed wiring boards, and therefore low thermal expansion properties and a high flexural modulus are required of resin compositions that are materials of insulating layers.

For example, in Patent Literatures 1 and 2, resin compositions comprising a cyanate compound and an epoxy resin that have excellent characteristics such as adhesiveness, low water absorbency, moisture absorption heat resistance, and insulation reliability are proposed.

In Patent Literature 3, an epoxy resin having a particular structure is disclosed, and it is disclosed that when a prepreg is formed with a blend of a phenol novolac resin as a curing agent and a predetermined curing catalyst with this epoxy resin, the obtained prepreg has excellent various characteristics including heat resistance and thermal conductivity. In this literature, as an intermediate for the above epoxy resin having a particular structure, a compound represented by the following formula (4) is disclosed.

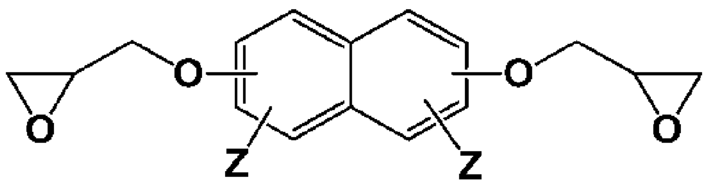

(4)

wherein Z each independently represents a hydrogen atom, a halogen atom, a hydrocarbon group having 1 to 8 carbon atoms, or an alkoxyl group having 1 to 8 carbon atoms. Further WO-A-2009/123058 discloses relevant epoxy resin compositions containing an epoxy resin component corresponding to component (A) of present claim 1.

### Citation List

#### Patent Literature

Patent Literature 1: International Publication No. WO 2016/062166
Patent Literature 2: International Publication No. WO 2014/203866
Patent Literature 3: Japanese Patent Laid-Open No. 2014-185271

Summary of Invention

Technical Problem

For example, in Patent Literatures 1 and 2, resin compositions comprising a cyanate compound and an epoxy resin that have excellent characteristics such as adhesiveness, low water absorbency, moisture absorption heat resistance, and insulation reliability are proposed, but improvements in thermal conductivity, a low linear thermal expansion coefficient, and a flexural modulus are still insufficient, and therefore further improvements in these characteristics are required. In Patent Literature 3, the compound represented by formula (4) is only described as an intermediate, and performance is not evaluated in Examples. In addition, in this literature, improving thermal conductivity, a low linear thermal expansion coefficient, and a flexural modulus in good balance is not studied.

Therefore, an object of the present invention is to provide a resin composition which can realize a printed wiring board and the like having excellent thermal conductivity, excellent low thermal expansion properties, and an excellent flexural modulus, and the present invention is to provide a prepreg and a resin sheet (for example, a single-layer or laminated sheet) using this resin composition, a metal foil-clad laminate using a prepreg, a printed wiring board, and the like.

Solution to Problem

The present inventors have diligently studied the above problem and, as a result, found that by using a resin composition containing an epoxy resin (A) represented by general formula (1) and a cyanate compound (B), a cured product having high thermal conductivity, a flexural modulus, and low thermal expansion properties is obtained, arriving at the present invention. Specifically, the present invention is as follows.

[1] A resin composition comprising an epoxy resin (A) represented by following general formula (1); and a cyanate compound (B),

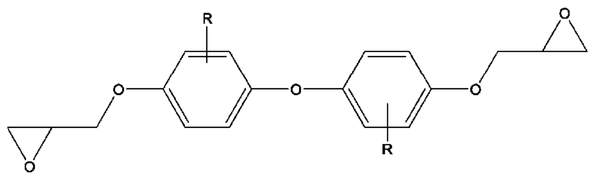

(1)

wherein R each independently represents an alkyl group having 1 to 3 carbon atoms, or a hydrogen atom.

[2] The resin composition of [1], wherein a content of the epoxy resin (A) in the resin composition is 1 to 90 parts by mass based on 100 parts by mass of a resin solid content.

[3] The resin composition of [1] or [2], further comprising one or more selected from the group consisting of an epoxy resin other than the epoxy resin (A), a maleimide compound, a phenolic resin, an oxetane resin, a benzoxazine compound, and a compound having a polymerizable unsaturated group.

[4] The resin composition of any of [1] to [3], wherein the cyanate compound (B) is one or more selected from the group consisting of a phenol novolac-based cyanate compound, a naphthol aralkyl-based cyanate compound, a biphenyl aralkyl-based cyanate compound, a naphthylene ether-based cyanate compound, a xylene resin-based cyanate compound, an adamantane skeleton-based cyanate compound, and a cyanate compound containing an allyl group or a propenyl group.

[5] The resin composition of [4], wherein the cyanate compound (B) comprises the naphthol aralkyl-based cyanate compound.

[6] The resin composition of any of [1] to [5], further comprising a filler (C).

[7] The resin composition of [6], wherein a content of the filler (C) in the resin composition is 50 to 1600 parts by mass based on 100 parts by mass of the resin solid content.

[8] A prepreg comprising a base material; and the resin composition according to any of [1] to [7] with which the base material is impregnated or coated.

[9] A metal foil-clad laminate comprising at least one or more of the prepregs of [8] laminated; and a metal foil disposed on one surface or both surfaces of the prepreg.

[10] A resin sheet comprising the resin composition of any of [1] to [7].

[11] A printed wiring board comprising an insulating layer; and a conductor layer formed on a surface of the insulating layer, wherein the insulating layer comprises the resin composition of any of [1] to [7].

Advantageous Effect of Invention

According to the present invention, a resin composition which can realize a printed wiring board and the like having excellent thermal conductivity, excellent low thermal expansion properties, and an excellent flexural modulus can be provided, and a prepreg and a resin sheet (for example, a single-layer or laminated sheet) using this resin composition, a metal foil-clad laminate using a prepreg, a printed wiring board, and the like can be provided.

Description of Embodiments

Embodiments of the present invention will be described below. Embodiments below are illustrations for describing the present invention, and the present invention is not limited to only the embodiments.

[Resin Composition]

A resin composition in this embodiment comprises an epoxy resin (A) represented by the following general formula (1); and a cyanate compound (B). When the resin composition in this embodiment contains the epoxy resin (A) and the cyanate compound (B), a prepreg, a resin sheet, a metal foil-clad laminate, and the like having excellent thermal conductivity, an excellent flexural modulus, and excellent low thermal expansion properties can be realized, and a high performance printed wiring board can be realized, and their industrial practicality is extremely high.

(Epoxy Resin (A))

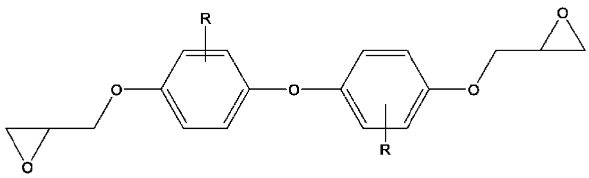

(1)

wherein R each independently represents an alkyl group having 1 to 3 carbon atoms (for example, a methyl group, an ethyl group, and a propyl group), or a hydrogen atom.

The method for producing the epoxy resin (A) represented by general formula (1) is not particularly limited, and, for example, the epoxy resin (A) can be obtained by glycidylating a corresponding bisphenol. In addition, for the epoxy resin (A) represented by general formula (1), commercial ones may be used, and, for example, "YSLV-80DE" manufactured by NIPPON STEEL & SUMIKIN CHEMICAL CO., LTD. can be preferably used. A resin cured product containing the epoxy resin (A) represented by general formula (1) has the effect of improving thermal conductivity, low thermal expansion properties, and a flexural modulus.

The content of the epoxy resin (A) represented by general formula (1) in the resin composition can be appropriately set according to the desired characteristics and is not particularly limited, but is preferably 1 to 90 parts by mass when the content of a resin solid content in the resin composition is 100 parts by mass. When the content is in the range of 1 to 90 parts by mass, a resin composition having excellent heat resistance is obtained. From a similar viewpoint, the content is more preferably 5 to 80 parts by mass, further preferably 10 to 70 parts by mass. Here, the "resin solid content in the resin composition" refers to components in the resin composition excluding a solvent and a filler (C), unless otherwise noted, and 100 parts by mass of the resin solid content refer to the total of the components in the resin composition excluding the solvent and the filler (C) being 100 parts by mass.

(Cyanate Compound (B))

The cyanate compound (B) used in this embodiment is not particularly limited as long as it is a resin having in the molecule an aromatic moiety substituted by at least one cyanato group (cyanate group).

Examples of the cyanate compound (B) include one represented by general formula (2):

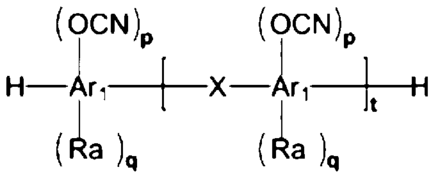

(2)

wherein $Ar_1$ each independently represents a phenylene group that may have a substituent, a naphthylene group that may have a substituent, or a biphenylene group that may have a substituent; Ra is each independently selected from any one of a hydrogen atom, an alkyl group having 1 to 6 carbon atoms that may have a substituent, an aryl group having 6 to 12 carbon atoms that may have a substituent, an alkoxyl group having 1 to 4 carbon atoms that may have a substituent, an aralkyl group that may have a substituent in which an alkyl group having 1 to 6 carbon atoms and an aryl group having 6 to 12 carbon atoms are bonded to each other, or an alkylaryl group that may have a substituent in which an alkyl group having 1 to 6 carbon atoms and an aryl group having 6 to 12 carbon atoms are bonded to each other; p represents the number of cyanato groups bonded to $Ar_1$ and is an integer of 1 to 3; q represents the number of Ra bonded to $Ar_1$ and is 4 - p when $Ar_1$ is a phenylene group, 6 - p when $Ar_1$ is a naphthylene group, and 8 - p when $Ar_1$ is a biphenylene group; t represents the average number of repetitions and is an integer of 0 to 50, and the cyanate compound may be a mixture of compounds having different t; and X is each independently selected from any one of a single bond, a divalent organic group having 1 to 50 carbon atoms (a hydrogen atom may be replaced by a heteroatom), a divalent organic group having 1 to 10 nitrogen atoms (-N-R-N-or the like), a carbonyl group (-CO-), a carboxy group (-C(=O)O-), a carbonyl dioxide group (-OC(=O)O-), a sulfonyl group ($-SO_2-$), or a divalent sulfur atom or a divalent oxygen atom.

The alkyl group represented by Ra in general formula (2) may have either of a chain structure and a cyclic structure (cycloalkyl group or the like).

In addition, a hydrogen atom in the alkyl group and the aryl group represented by Ra in general formula (2) may be replaced by a halogen atom such as fluorine or chlorine, an alkoxyl group such as a methoxy group or a phenoxy group, a cyano group, or the like.

Specific examples of the alkyl group include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Specific examples of the aryl group include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group. Further, examples of the alkoxyl group include a methoxy group, an ethoxy group, a propoxy group, an isopropoxy group, a n-butoxy group, an isobutoxy group, and a tert-butoxy group.

Specific examples of the divalent organic group represented by X in general formula (2) include a methylene group, an ethylene group, a trimethylene group, a cyclopentylene group, a cyclohexylene group, a trimethylcyclohexylene group, a biphenylylmethylene group, a dimethylmethylene-phenylene-dimethylmethylene group, a fluorenediyl group, and a phthalidediyl group. A hydrogen atom in the divalent organic group may be replaced by a halogen atom such as fluorine or chlorine, an alkoxyl group such as a methoxy group or a phenoxy group, a cyano group, or the like.

Examples of the divalent organic group having 1 to 10 nitrogen atoms for X in general formula (2) include an imino group and a polyimide group.

In addition, examples of X in general formula (2) include one having a structure represented by the following general formula (3) or the following general formula (4).

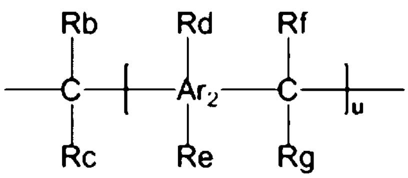

(3)

wherein $Ar_2$ is selected from any one of a phenylene group, a naphthylene group, and a biphenylene group; Rb, Rc, Rf, and Rg are each independently selected from any one of a hydrogen atom, an alkyl group having 1 to 6 carbon atoms, an aryl group having 6 to 12 carbon atoms, a trifluoromethyl group, and an aryl group substituted by at least one phenolic hydroxy group; Rd and Re are each independently selected from any one of a hydrogen atom, an alkyl group having 1 to 6 carbon atoms, an aryl group having 6 to 12 carbon atoms, an alkoxyl group having 1 to 4 carbon atoms, and a hydroxy group; and u represents an integer of 0 to 5, and the cyanate compound may be a mixture of compounds having

different u.

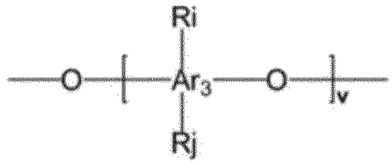 (4)

wherein $Ar_3$ is selected from any one of a phenylene group, a naphthylene group, or a biphenylene group; Ri and Rj are each independently selected from any one of a hydrogen atom, an alkyl group having 1 to 6 carbon atoms, an aryl group having 6 to 12 carbon atoms, a benzyl group, an alkoxyl group having 1 to 4 carbon atoms, a hydroxy group, a trifluoromethyl group, and an aryl group substituted by at least one cyanato group; and v represents an integer of 0 to 5, and the cyanate compound may be a mixture of compounds having different v.

Further, examples of X in general formula (2) include divalent groups represented by the following formulas:

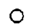
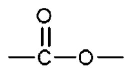
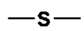
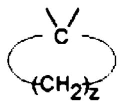
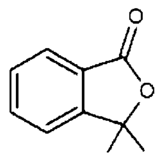

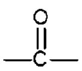
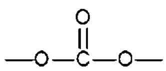
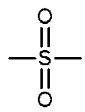
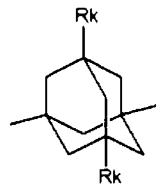
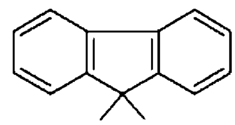

wherein z represents an integer of 4 to 7; and Rk each independently represents a hydrogen atom or an alkyl group having 1 to 6 carbon atoms.

Specific examples of $Ar_2$ in general formula (3) and $Ar_3$ in general formula (4) include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group represented by Rb to Rg in general formula (3) and Ri and Rj in general formula (4) are similar to those described in general formula (2).

Specific examples of the cyanato-substituted aromatic compound represented by general formula (2) include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3,5-dimethylbenzene, cyanatoethylbenzene, cyanatobutylbenzene, cyanatooctylbenzene, cyanatononylbenzene, 2-(4-cyanaphenyl)-2-phenylpropane (a cyanate of 4-$\alpha$-cumylphenol), 1-cyanato-4-cyclohexylbenzene, 1-cyanato-4-vinylbenzene, 1-cyanato-2-or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2-or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl) ether, bis(4-cyanatophenyl) sulfide, bis(4-cyanatophenyl) sulfone, 4-cyanatobenzoic acid-4-cyanatophenyl ester (4-cyanatophenyl-4-cyanatobenzoate), bis-(4-cyanatophenyl) carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, $\alpha,\alpha,\alpha'$-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl) isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, those obtained by cyanation of phenolic resins such as phenol novolac resins and cresol novolac resins (those obtained by reacting a phenol, an alkyl-substituted phenol, or a halogen-substituted phenol and a formaldehyde compound such as formalin or paraformaldehyde in an acidic solution by a known method), trisphenol novolac resins (those obtained by reacting hydroxybenzaldehyde and a phenol in the presence of an acidic catalyst), fluorene novolac resins (those obtained by reacting a fluorenone compound and a 9,9-bis(hydroxyaryl)fluorene in the presence of an acidic catalyst), phenol aralkyl resins, cresol aralkyl resins, naphthol aralkyl resins, and biphenyl aralkyl resins (those obtained by reacting a bishalogenomethyl compound as represented by $Ar_4$-$(CH_2Y)_2$ and a phenol compound with an acidic catalyst or without a catalyst, those obtained by reacting a bis(alkoxymethyl) compound as represented by $Ar_5$-$(CH_2OR)_2$ or a bis(hydroxymethyl) compound as represented by $Ar_6$-$(CH_2OH)_2$ and a phenol compound in the presence of an acidic catalyst, or those obtained by polycondensing an aromatic aldehyde compound, an aralkyl compound, and a phenol compound by a known method), phenol-modified xylene formaldehyde resins (those obtained by reacting a xylene formaldehyde resin and a phenol compound in the presence of an acidic catalyst by a known method), modified naphthalene formaldehyde resins (those obtained by reacting a naphthalene formaldehyde resin and a hydroxy-substituted aromatic compound in the presence of an acidic catalyst by a known method), phenol-modified dicyclopentadiene resins, and phenolic resins having a polynaphthylene ether structure (those obtained by subjecting a polyvalent hydroxynaphthalene compound having two or more phenolic hydroxy groups in one molecule to dehydration condensation in the presence of a basic catalyst by a known method) by a method similar to the above but are not particularly limited. One of these cyanate compounds can be used, or two or more of these cyanate compounds can be mixed and used. Specific examples of the above $Ar_4$, $Ar_5$, and $Ar_6$ include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

For the cyanate compound (B), among these, from the viewpoint of even better thermal conductivity, even better low thermal expansion properties, and an even better flexural modulus, phenol novolac-based cyanate compounds, naphthol aralkyl-based cyanate compounds, biphenyl aralkyl-based cyanate compounds, naphthylene ether-based cyanate compounds, xylene resin-based cyanate compounds, adamantane skeleton-based cyanate compounds, and cyanate compounds containing an allyl group or a propenyl group are preferred, and naphthol aralkyl-based cyanate compounds are more preferred.

Examples of the cyanate compound containing an allyl group or a propenyl group include a cyanate compound represented by the following formula (1A):

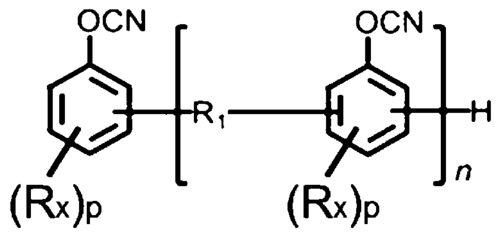

(1 A)

wherein n represents the average value of the number of repeating units and represents a number of 1 to 50, $R_1$ represents any of a single bond, a divalent organic group having 1 to 50 carbon atoms, a divalent organic group having 1 to 10 nitrogen atoms, a carbonyl group (-CO-), a carboxy group (-C(=O)O-), a carbonyl dioxide group (-OC(=O)O-), a sulfonyl group ($-SO_2-$), a divalent sulfur atom (-S-), and a divalent oxygen atom (-O-), $R_x$ represents an allyl group or a propenyl group, p each independently represents an integer of 1 or more, and when there are a plurality of $R_1$, the plurality of $R_1$ may be the same or different.

The compound represented by formula (1A) may be in the form of comprising a compound in which the number of repeating units, n, in formula (1A) is the same, and $R_1$ is the same, may be in the form of a mixture of compounds in which the number of repeating units, n, in formula (1A) is different, or may be in the form of a mixture of compounds in which $R_1$ in formula (1A) is different. n in formula (1A) represents the average value of the number of repeating units and is 1 to 50.

In formula (1A), $R_1$ represents any of a single bond, a divalent organic group having 1 to 50 carbon atoms, a divalent organic group having 1 to 10 nitrogen atoms (for example, a group represented by formula: -N-R-N- (wherein R represents a divalent hydrocarbon group), an imino group, or a polyimide group), a carbonyl group (-CO-), a carboxy group (-C(=O)O-), a carbonyl dioxide group (-OC(=O)O-), a sulfonyl group ($-SO_2-$), a divalent sulfur atom (-S-), and a divalent oxygen atom (-O-), and when there are a plurality of $R_1$, the plurality of $R_1$ may be the same or different. In addition, the bonding positions of $R_1$ to the aromatic rings are not particularly limited. Among these, a divalent organic group having 1 to 50 carbon atoms (hereinafter also referred to as a "particular divalent organic group") is preferred.

Examples of the particular divalent organic group include divalent hydrocarbon groups that may have a heteroatom. Examples of the above divalent hydrocarbon groups include alkylene groups (for example, alkylene groups having 1 to 10 carbon atoms, such as a methylene group, an ethylene group, a trimethylene group, and a propylene group), alkylidene groups (for example, alkylidene groups having 1 to 10 carbon atoms, such as an ethylidene group and a 2,2-propylidene group), cycloalkylene groups (for example, a cyclopentylene group, a cyclohexylene group, and a trimethylcyclohexylene group), cycloalkylidene group (for example, cycloalkylidene groups having 5 to 8 carbon atoms), and divalent organic groups having an aromatic ring (for example, a biphenylylmethylene group, a fluorenediyl group, a phthalidediyl group, and a group represented by formula: - $(CH_3)C(CH_3)$-Ph-$(CH_3)C(CH_3)$-wherein Ph represents a phenylene group). A hydrogen atom in these divalent organic groups may be replaced by a substituent. Examples of the substituent include halogen atoms (for example, a fluorine atom and a chlorine atom), alkoxy groups (for example, a methoxy group and a phenoxy group), and a cyano group.

In formula (1A), $R_x$ represents an allyl group or a propenyl group. p each independently represents an integer of 1 or more (preferably 1).

The content of the cyanate compound (B) in the resin composition can be appropriately set according to the desired characteristics and is not particularly limited, but is preferably 1 to 90 parts by mass when the content of the resin solid content in the resin composition is 100 parts by mass. When the content is in the range of 1 to 90 parts by mass, a resin composition having even better low thermal expansion properties, even better thermal conductivity, and an even better flexural modulus is obtained. From a similar viewpoint, the content is more preferably 5 to 80 parts by mass, further preferably 10 to 70 parts by mass.

(Filler (C))

The resin composition in this embodiment preferably further contains the filler (C) from the viewpoint of even more improving moldability, thermal conductivity, and low thermal expansion characteristics.

As the filler (C) used in this embodiment, known ones can be appropriately used, and the type of the filler (C) is not particularly limited. Those generally used in the industry can be preferably used. Specific examples include inorganic fillers such as silicas such as natural silica, fused silica, synthetic silica, amorphous silica, AEROSIL, and hollow silica, white carbon, titanium white, zinc oxide, magnesium oxide, zirconium oxide, boron nitride, aggregated boron nitride, silicon nitride, aluminum nitride, barium sulfate, metal hydrates such as aluminum hydroxide, heat-treated products of aluminum hydroxide (products obtained by heat-treating aluminum hydroxide to decrease some of the water of crystallization), boehmite, and magnesium hydroxide, molybdenum compounds such as molybdenum oxide and zinc molybdate, zinc borate, zinc stannate, alumina, clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass as well as organic fillers such as rubber powders such as styrene-based rubber powders, butadiene-based rubber powders, and acrylic rubber powders, core-shell-based rubber powders, silicone resin powders, silicone rubber powders, and silicone composite powders. One of these fillers can be used alone, or two or more of these fillers can be used in combination.

For the filler (C), among these, one or more selected from the group consisting of silica, aluminum hydroxide, boehmite, magnesium oxide, and magnesium hydroxide are preferred. By using these fillers, the characteristics, such as thermal expansion characteristics, dimensional stability, and flame retardancy, of the resin composition tend to improve.

The content of the filler (C) in the resin composition can be appropriately set according to the desired characteristics and is not particularly limited, but is preferably 50 to 1600 parts by mass when the content of the resin solid content in the resin composition is 100 parts by mass. When the content is in the range of 50 to 1600 parts by mass, the moldability of the resin composition tends to be even better, and the characteristics such as thermal conductivity and thermal expansion characteristics tend to improve even more. From a similar viewpoint, the content is more preferably 60 to 1200 parts by mass, further preferably 70 to 1000 parts by mass.

Here, when the filler (C) is used, a silane coupling agent and a wetting and dispersing agent are preferably used in combination. As the silane coupling agent, those generally used for surface treatment of inorganic matter can be preferably used, and the type of the silane coupling agent is not particularly limited. Specific examples include aminosilane-based such as γ-aminopropyltriethoxysilane and N-β-(aminoethyl)-γ-aminopropyltrimethoxysilane; epoxysilane-based such as γ-glycidoxypropyltrimethoxysilane and β-(3,4-epoxycyclohexyl)ethyltrimethoxysilane; vinylsilane-based such as γ-methacryloxypropyltrimethoxysilane and vinyl-tri(β-methoxyethoxy)silane; cationic silane-based such as N-β-(N-vinylbenzylaminoethyl)-γ-aminopropyltrimethoxysilane hydrochloride; and phenylsilane-based. One of these silane coupling agents can be used alone, or two or more of these silane coupling agents can be used in combination. In addition, as the wetting and dispersing agent, those generally used for paints can be preferably used, and the type of the wetting and dispersing agent is not particularly limited. Preferably, copolymer-based wetting and dispersing agents are used. Specific examples thereof include Disperbyk-110, 111, 161, and 180, BYK-W996, BYK-W9010, BYK-W903, and BYK-W940 manufactured by BYK Japan KK. One of these wetting and dispersing agents can be used alone, or two or more of these wetting and dispersing agents can be used in combination.

Further, the resin composition in this embodiment may contain one or more selected from the group consisting of an epoxy resin other than the epoxy resin (A) (hereinafter referred to as "another epoxy resin"), a maleimide compound, a phenolic resin, an oxetane resin, a benzoxazine compound, and a compound having a polymerizable unsaturated group, in a range in which the expected characteristics are not impaired. By using these resins in combination, the desired characteristics, such as flame retardancy and low dielectric properties, of a cured product obtained by curing the resin composition can be improved.

As the another epoxy resin, known ones can be appropriately used as long as they are epoxy resins that are not represented by general formula (1) and that have two or more epoxy groups in one molecule. The type of the another epoxy resin is not particularly limited. Specific examples include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, aralkyl novolac-based epoxy resins, biphenyl aralkyl-based epoxy resins, naphthylene ether-based epoxy resins, cresol novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing double bonds of butadiene and the like, and compounds obtained by reaction of hydroxyl group-containing silicone resins and epichlorohydrin. Among these epoxy resins, biphenyl aralkyl-based epoxy resins, naphthylene ether-based epoxy resins, polyfunctional phenol-based epoxy resins, and naphthalene-based epoxy resins are preferred in terms of flame retardancy and heat resistance. One of these epoxy resins can be used alone, or two or more of these epoxy resins can be used in combination.

As the maleimide compound, those generally known can be used as long as they are compounds having one or more maleimide groups in one molecule. Examples of the maleimide compound include 4,4-diphenylmethanebismaleimide, phenylmethanemaleimide, m-phenylenebismaleimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, polyphenylmethanemaleimide, novolac-based maleimides, biphenyl aralkyl-based maleimides, and prepolymers of these maleimide compounds or prepolymers of maleimide compounds and amine compounds but are not particularly limited. One of these maleimide compounds can be used, or two or more of these maleimide compounds can be mixed and used. Among these, novolac-based maleimide compounds and biphenyl aralkyl-based maleimide compounds are particularly preferred.

As the phenolic resin, those generally known can be used as long as they are phenolic resins having two or more hydroxyl groups in one molecule. Examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, and hydroxyl group-containing silicone resins but are not particularly limited. Among these phenolic resins, biphenyl aralkyl-based phenolic resins, naphthol aralkyl-based phenolic resins, phosphorus-containing phenolic resins, and hydroxyl group-containing silicone resins are preferred in terms of flame retardancy. One of these phenolic resins can be used alone, or two or more of these phenolic resins can be used in combination.

As the oxetane resin, those generally known can be used. Examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3-di(trifluoromethyl)perfluoxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.) and are not particularly limited. One of these oxetane resins can be used, or two or more of these oxetane resins can be mixed and used.

As the benzoxazine compound, those generally known can be used as long as they are compounds having two or more dihydrobenzoxazine rings in one molecule. Examples of the benzoxazine compound include bisphenol A-based benzoxazine BA-BXZ (trade name manufactured by Konishi Chemical Ind. Co., Ltd.), bisphenol F-based benzoxazine BF-BXZ (trade name manufactured by Konishi Chemical Ind. Co., Ltd.), bisphenol S-based benzoxazine BS-BXZ (trade name manufactured by Konishi Chemical Ind. Co., Ltd.), P-d-based benzoxazine (trade name manufactured by SHIKOKU CHEMICALS CORPORATION), and F-a-based benzoxazine (trade name manufactured by SHIKOKU CHEMICALS CORPORATION) and are not particularly limited. One of these benzoxazine compounds can be used, or two or more of these benzoxazine compounds can be mixed and used.

As the compound having a polymerizable unsaturated group, those generally known can be used. Examples of the compound having a polymerizable unsaturated group include vinyl compounds such as ethylene, propylene, styrene, divinylbenzene, and divinylbiphenyl; (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A-based epoxy (meth)acrylate and bisphenol F-based epoxy (meth)acrylate; benzocyclobutene resins; and (bis)maleimide resins and are not particularly limited. One of these compounds having an unsaturated group can be used, or two or more of these compounds having an unsaturated group can be mixed and used.

In addition, the resin composition in this embodiment may contain a curing accelerator for appropriately adjusting the curing rate, as needed. As this curing accelerator, those generally used as curing accelerators for cyanate compounds, epoxy resins, and the like can be preferably used, and the type of the curing accelerator is not particularly limited. Specific examples thereof include organometallic salts such as zinc octylate, zinc naphthenate, cobalt naphthenate, copper naphthenate, acetylacetone iron, nickel octylate, and manganese octylate; phenol compounds such as phenol, xylenol, cresol, resorcin, catechol, octyl phenol, and nonyl phenol; alcohols such as 1-butanol and 2-ethylhexanol; imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole and derivatives such as adducts of carboxylic acids of these imidazoles or acid anhydrides thereof; amines such as dicyandiamide, benzyldimethylamine, 4-methyl-N,N-dimethylbenzylamine, N,N-dimethylbenzylamine, N,N-dimethylaniline, N,N-dimethyltoluidine, N,N-dimethylaminopyridine, 2-N-ethylanilinoethanol, tri-n-butylamine, dimethylpyridine, pyridine, quinoline, N-methylmorpholine, triethanolamine, triethylenediamine, tetramethylbutanediamine, and N-methylpiperidine; phosphorus compounds such as phosphine-based compounds, phosphine oxide-based compounds, phosphonium salt-based compounds, and diphosphine-based compounds; epoxy-imidazole adduct-based compounds; peroxides such as benzoyl peroxide, p-chlorobenzoyl peroxide, di-t-butyl peroxide, diisopropyl peroxycarbonate, and di-2-ethylhexyl peroxycarbonate; or azo compounds such as azobisisobutyronitrile. One of these curing accelerators can be used alone, or two or more of these curing accelerators can be used in combination.

The amount of the curing accelerator used can be appropriately adjusted considering the degrees of cure of the resins, the viscosity of the resin composition, and the like and is not particularly limited but is generally 0.005 to 10

parts by mass based on 100 parts by mass of the resin solid content in the resin composition.

Further, various polymer compounds such as another thermosetting resin, a thermoplastic resin and an oligomer thereof, and an elastomer, a flame-retardant compound, various additives, and the like can be used in combination in the resin composition in this embodiment in a range in which the expected characteristics are not impaired. These are not particularly limited as long as they are those generally used. Examples of the flame-retardant compound include bromine compounds such as 4,4'-dibromobiphenyl, phosphates, melamine phosphate, phosphorus-containing epoxy resins, nitrogen compounds such as melamine and benzoguanamine, oxazine ring-containing compounds, and silicone-based compounds. In addition, examples of the various additives include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in combination as desired.

An organic solvent can be used in the resin composition in this embodiment as needed. In this case, the resin composition of the present invention can be used as a form (solution or varnish) in which at least some, preferably all, of the above-described various resin components are dissolved in or compatible with the organic solvent. As the organic solvent, known ones can be appropriately used as long as they can dissolve or be compatible with at least some, preferably all, of the above-described various resin components. The type of the organic solvent is not particularly limited. Specific examples include polar solvents such as ketones such as acetone, methyl ethyl ketone, and methyl isobutyl ketone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, ethyl lactate, methyl methoxypropionate, and methyl hydroxyisobutyrate; and amides such as dimethylacetamide and dimethylformamide; and nonpolar solvents such as aromatic hydrocarbons such as toluene and xylene. One of these can be used alone, or two or more of these can be used in combination.

The resin composition in this embodiment can be prepared according to an ordinary method, and the method for adjusting the resin composition in this embodiment is not particularly limited as long as it is a method in which a resin composition uniformly containing the epoxy resin (A) represented by general formula (1) and the cyanate compound (B) and the above-described other optional components is obtained. For example, the resin composition in this embodiment can be easily obtained by sequentially blending the epoxy resin (A) represented by general formula (1) and the cyanate compound (B) with a solvent and sufficiently stirring the blend.

During preparation of the resin composition, known treatment (stirring, mixing, and kneading treatment and the like) for uniformly dissolving or dispersing the components can be performed. For example, in uniform dispersion of the filler (C), by performing stirring and dispersion treatment using a stirring vessel provided with a stirrer having suitable stirring ability, the dispersibility in the resin composition is increased. The above stirring, mixing, and kneading treatment can be appropriately performed, for example, using a known apparatus such as an apparatus intended for mixing such as a ball mill or a bead mill, or a revolution-rotation mixing apparatus.

The resin composition in this embodiment can be used as an insulating layer of a printed wiring board and a semiconductor package material. For example, a prepreg can be provided by impregnating or coating a base material with a solution of the resin composition of the present invention dissolved in a solvent and drying the solution.

In addition, a resin sheet can be provided by drying a solution of the resin composition in this embodiment dissolved in a solvent. The resin sheet can be used as a buildup film or a dry film solder resist.

In addition, the resin composition in this embodiment can also be used in an uncured state in which the solvent is only dried, or in a semi-cured (B-staged) state as needed.

A prepreg in this embodiment will be described in detail below. The prepreg in this embodiment is one obtained by impregnating or coating a base material with the resin composition in this embodiment described above. The method for producing the prepreg is not particularly limited as long as it is a method of combining the resin composition in this embodiment and a base material to produce a prepreg. Specifically, the prepreg in this embodiment can be produced by impregnating or coating a base material with the resin composition in this embodiment and then semi-curing the resin composition by a method of drying at 120 to 220°C for about 2 to 15 minutes, or the like. At this time, the amount of the resin composition adhered to the base material, that is, the amount of the resin composition (including the filler (C)) based on the total amount of the prepreg after the semi-curing, is preferably in the range of 20 to 99% by mass.

As the base material used when the prepreg in this embodiment is produced, known ones used for various printed wiring board materials can be used. Examples of the base material include, but are not particularly limited to, woven fabrics of fibers of glass such as E glass, D glass, L glass, S glass, T glass, Q glass, UN glass, NE glass, and spherical glass; inorganic fibers of materials other than glass, such as quartz; organic fibers of polyimides, polyamides, polyesters, and the like; liquid crystal polyesters; and the like. As the shape of the base material, woven fabrics, nonwoven fabrics, rovings, chopped strand mats, surfacing mats, and the like are known, and the shape of the base material may be any. One of these base materials can be used alone, or two or more of these base materials can be used in combination. In addition, the thickness of the base material is not particularly limited, but is preferably in the range of 0.01 to 0.2 mm in laminate applications. Particularly, woven fabrics subjected to ultra-opening treatment or clogging treatment are

preferred from the viewpoint of dimensional stability. Further, glass woven fabrics surface-treated with silane coupling agents for epoxysilane treatment, aminosilane treatment, and the like are preferred from the viewpoint of moisture absorption heat resistance. In addition, liquid crystal polyester woven fabrics are preferred in terms of electrical characteristics.

In addition, a metal foil-clad laminate in this embodiment is one obtained by stacking at least one or more of the above-described prepregs, disposing metal foil on one surface or both surfaces of the stack, and laminate-molding the metal foil and the stack. Specifically, the metal foil-clad laminate in this embodiment can be fabricated by stacking one or a plurality of the above-described prepregs, disposing foil of a metal such as copper or aluminum on one surface or both surfaces of the stack, and laminate-molding the metal foil and the stack. The metal foil used here is not particularly limited as long as it is one used for a printed wiring board material. Copper foil such as rolled copper foil and electrolytic copper foil is preferred. In addition, the thickness of the metal foil is not particularly limited but is preferably 2 to 70 μm, more preferably 3 to 35 μm. As the molding conditions, usual methods for laminates and multilayer boards for printed wiring boards can be applied. For example, the metal foil-clad laminate of the present invention can be produced by laminate-molding with a temperature of 180 to 350°C, a heating time of 100 to 300 minutes, and a surface pressure of 20 to 100 $kg/cm^2$ using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. As the method for producing a multilayer board, for example, a multilayer board can be fabricated by disposing 35 μm copper foil on both surfaces of one of the above-described prepreg, laminating and forming the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum.

The metal foil-clad laminate in this embodiment can be preferably used as a printed wiring board. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer board. The inner layer circuit surfaces of this inner layer board are subjected to surface treatment for increasing adhesive strength, as needed. Then, the required number of the above-described prepregs are stacked on the inner layer circuit surfaces, metal foil for outer layer circuits is further laminated on the outside of the stack, and heat and pressure are applied for integral molding. In this manner, a multilayer laminate in which insulating layers comprising a base material and a cured product of a thermosetting resin composition are formed between inner layer circuits and metal foil for outer layer circuits is produced. Then, this multilayer laminate is subjected to perforation for through holes and via holes, and then plating metal films that allow conduction between the inner layer circuits and the metal foil for outer layer circuits are formed on the wall surfaces of these holes. Further, the metal foil for outer layer circuits is subjected to etching treatment to form outer layer circuits. Thus, a printed wiring board is produced.

The printed wiring board obtained in the above production example has a configuration in which it has insulating layers and conductor layers formed on surfaces of these insulating layers, and the insulating layers comprise the resin composition in this embodiment described above. In other words, the prepreg in this embodiment described above (the base material and the resin composition in this embodiment with which the base material is impregnated or coated) and the resin composition layer of the metal foil-clad laminate in this embodiment described above (the layer comprising the resin composition of the present invention) are composed of an insulating layer comprising the resin composition in this embodiment.

A resin sheet in this embodiment comprises the resin composition in this embodiment. The resin sheet in this embodiment can be obtained by coating a support with a solution of the above resin composition dissolved in a solvent and drying the solution. The support used here is not particularly limited. Examples thereof include organic film base materials such as polyethylene films, polypropylene films, polycarbonate films, polyethylene terephthalate films, ethylene-tetrafluoroethylene copolymer films, and release films obtained by coating surfaces of these films with release agents, and polyimide films; conductor foil such as copper foil and aluminum foil; and plate-shaped inorganic films such as glass plates, SUS plates, and FRP. Examples of the method for coating include a method of coating a support with a solution of the above resin composition dissolved in a solvent by a bar coater, a die coater, a doctor blade, a baker applicator, or the like to fabricate a laminated sheet in which a support and a resin sheet are integrated. In addition, a single-layer sheet (resin sheet) can also be provided by peeling or etching the support from the laminated sheet after drying. A single-layer sheet (resin sheet) can also be obtained without using a support by supplying a solution of the above resin composition in this embodiment dissolved in a solvent into a mold having a sheet-shaped cavity, and drying the solution, or the like for molding into a sheet shape.

In fabrication of the resin sheet (single-layer or laminated sheet) in this embodiment, the drying conditions when

the solvent is removed are not particularly limited but are preferably a temperature of 20°C to 200°C for 1 to 90 minutes because at low temperature, the solvent is likely to remain in the resin composition, and at high temperature, curing of the resin composition proceeds. In addition, the thickness of the resin layer of the resin sheet (single-layer or laminated sheet) in this embodiment can be adjusted by the concentration and coating thickness of the solution of the resin composition in this embodiment and is not particularly limited but is preferably 0.1 to 500 μm because generally, when the coating thickness increases, the solvent is likely to remain during drying.

Examples

The present invention will be described in more detail below by showing Synthesis Examples, an Example, and a Comparative Example, but the present invention is not limited to these.

(Synthesis Example 1) Synthesis of Cyanate Compound

300 g (1.28 mol in terms of OH groups) of a 1-naphthol aralkyl resin (manufactured by NIPPON STEEL & SUMIKIN CHEMICAL CO., LTD.) and 194.6 g (1.92 mol) (1.5 mol based on 1 mol of hydroxy groups) of triethylamine were dissolved in 1800 g of dichloromethane, and this solution was a solution 1. While 125.9 g (2.05 mol) (1.6 mol based on 1 mol of hydroxy groups) of cyanogen chloride, 293.8 g of dichloromethane, 194.5 g (1.92 mol) (1.5 mol based on 1 mol of hydroxy groups) of 36% hydrochloric acid, and 1205.9 g of water were kept at a liquid temperature of -2 to -0.5°C under stirring, the solution 1 was poured over 30 minutes. After completion of pouring of the solution 1, the mixture was stirred at the same temperature for 30 minutes, and then a solution of 65 g (0.64 mol) (0.5 mol based on 1 mol of hydroxy groups) of triethylamine dissolved in 65 g of dichloromethane (also referred to as a "solution 2") was poured over 10 minutes. After completion of pouring of the solution 2, the mixture was stirred at the same temperature for 30 minutes to complete the reaction. Then, the reaction liquid was allowed to stand to separate the organic phase and the aqueous phase. The obtained organic phase was washed five times with 1300 g of water. The electrical conductivity of the wastewater from the fifth water washing was 5 μS/cm, and it was confirmed that removable ionic compounds were sufficiently removed by the washing with water. The organic phase after the water washing was concentrated under reduced pressure and finally concentrated to dryness at 90°C for 1 hour to obtain 331 g of the target naphthol aralkyl-based cyanate compound (SNCN) (orange viscous material). The mass average molecular weight Mw of the obtained SNCN was 600. In addition, the IR spectrum of SNCN showed absorption at 2250 $cm^{-1}$ (cyanate groups) and showed no absorption of hydroxy groups.

(Example 1)

50 parts by mass of the SNCN obtained by Synthesis Example 1, 50 parts by mass of an epoxy resin represented by general formula (1) (YSLV-80DE, manufactured by NIPPON STEEL & SUMIKIN CHEMICAL CO., LTD.), 100 parts by mass of fused silica (SC2050MB, manufactured by Admatechs Company Limited), and 0.10 parts by mass of zinc octylate (manufactured by Nihon Kagaku Sangyo Co., Ltd.) were mixed to obtain a varnish. This varnish was diluted with methyl ethyl ketone, and an E-glass woven fabric having a thickness of 0.1 mm was impregnated and coated with the diluted varnish and heated and dried at 150°C for 5 minutes to obtain a prepreg having a resin content of 50% by mass.

Eight of the obtained prepregs were stacked, and 12 μm thick electrolytic copper foil (3EC-M3-VLP, manufactured by MITSUI MINING & SMELTING CO., LTD.) was disposed on the top and the bottom. The stack was laminate-molded at a pressure of 30 $kgf/cm^2$ and a temperature of 220°C for 120 minutes to obtain a metal foil-clad laminate having an insulating layer thickness of 0.8 mm. Evaluation of thermal conductivity, thermal expansion coefficients, and a flexural modulus was performed using the obtained metal foil-clad laminate. The results are shown in Table 1.

(Comparative Example 1)

A metal foil-clad laminate having a thickness of 0.8 mm was obtained as in Example 1 except that 50 parts by mass of a biphenyl aralkyl-based epoxy resin (NC-3000-FH, manufactured by Nippon Kayaku Co., Ltd.) was used instead of using 50 parts by mass of the epoxy resin represented by general formula (1) in Example 1. The evaluation results of the obtained metal foil-clad laminate are shown in Table 1.

(Measurement Methods and Evaluation Methods)

1) Flexural modulus: The copper foil on both surfaces of each of the obtained eight-ply metal foil-clad laminates

was removed by etching. Then, in accordance with JIS C6481, using a test piece (50 mm × 25 mm × 0.8 mm), the flexural modulus was measured with the number of tests being 5, and the average value of the maximum values was the measured value.

2) Thermal expansion coefficients: For each of the obtained eight-ply metal foil-clad laminates, the thermal expansion coefficients (CTE) in the longitudinal direction (described as "CTE-y $\alpha$1" in the table), transverse direction (described as "CTE-x $\alpha$1" in the table), and height direction (described as "CTE-z $\alpha$1" in the table) of the glass cloths for the insulating layer of the laminate were measured by the TMA method (Thermo-mechanical analysis) defined in JIS C 6481, and the values were obtained. Specifically, the copper foil on both surfaces of each of the metal foil-clad laminates obtained above was removed by etching, then the temperature was increased by 10°C per minute from 40°C to 340°C by a thermo-mechanical analysis apparatus (manufactured by TA Instruments), and the thermal expansion coefficients at 60°C to 120°C (ppm/°C) were measured.

3) Thermal conductivity: The density of each of the obtained eight-ply metal foil-clad laminates was measured, and the specific heat was measured by a DSC (TA Instruments model Q100), and further the thermal diffusivity was measured by a xenon flash analyzer (Bruker: LFA447 Nanoflash). The thermal conductivity was calculated from the following formula:

$$\text{thermal conductivity (W/m}\cdot\text{K)} = \text{density (kg/m}^3) \times \text{specific heat (kJ/kg}\cdot\text{K)} \times \text{thermal diffusivity (m}^2\text{/S)} \times 1000$$

[Table 1]

| | | Example 1 | Comparative Example 1 |
|---|---|---|---|
| Flexural modulus 0.8 mmt | [GPa] | 33.1 | 31.7 |
| Thermal expansion coefficients | CTE-x $\alpha$1 [ppm/K] | 10.6 | 12.6 |
| | CTE-y $\alpha$1 [ppm/K] | 10.4 | 11.6 |
| | CTE-z $\alpha$1 [ppm/K] | 16.2 | 26.4 |
| Thermal conductivity measurement | W/m·K | 0.79 | 0.68 |

As is clear from Table 1, it was confirmed that by using the resin composition of the present invention, a prepreg, a printed wiring board, and the like having high thermal conductivity and bending elasticity and low thermal expansion properties were realized.

This application claims the priority of Japanese Patent Application No. 2017-077757 filed on April 10, 2017.

Industrial Applicability

As described above, the resin composition of the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials, and, particularly, can be especially effectively used as printed wiring board materials adapted to higher integration and higher density for information terminal equipment, communication equipment, and the like in recent years. In addition, the metal foil-clad laminate, resin sheet, and printed wiring board of the present invention have performance excellent in thermal conductivity, low thermal expansion properties, and a flexural modulus, and therefore their industrial practicality is extremely high.

## Claims

1. A resin composition comprising an epoxy resin (A) represented by following general formula (1); and a cyanate compound (B),

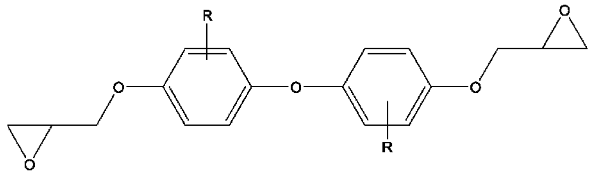

(1)

wherein R each independently represents an alkyl group having 1 to 3 carbon atoms, or a hydrogen atom.

2. The resin composition according to claim 1, wherein a content of the epoxy resin (A) in the resin composition is 1 to 90 parts by mass based on 100 parts by mass of a resin solid content.

3. The resin composition according to claim 1 or 2, further comprising one or more selected from the group consisting of an epoxy resin other than the epoxy resin (A), a maleimide compound, a phenolic resin, an oxetane resin, a benzoxazine compound, and a compound having a polymerizable unsaturated group.

4. The resin composition according to any one of claims 1 to 3, wherein the cyanate compound (B) is one or more selected from the group consisting of a phenol novolac-based cyanate compound, a naphthol aralkyl-based cyanate compound, a biphenyl aralkyl-based cyanate compound, a naphthylene ether-based cyanate compound, a xylene resin-based cyanate compound, an adamantane skeleton-based cyanate compound, and a cyanate compound containing an allyl group or a propenyl group.

5. The resin composition according to claim 4, wherein the cyanate compound (B) comprises the naphthol aralkyl-based cyanate compound.

6. The resin composition according to any one of claims 1 to 5, further comprising a filler (C).

7. The resin composition according to claim 6, wherein a content of the filler (C) in the resin composition is 50 to 1600 parts by mass based on 100 parts by mass of the resin solid content.

8. A prepreg comprising a base material; and the resin composition according to any one of claims 1 to 7 with which the base material is impregnated or coated.

9. A metal foil-clad laminate comprising at least one or more of the prepregs according to claim 8 laminated; and a metal foil disposed on one surface or both surfaces of the prepreg.

10. A resin sheet comprising the resin composition according to any one of claims 1 to 7.

11. A printed wiring board comprising an insulating layer; and a conductor layer formed on a surface of the insulating layer, wherein the insulating layer comprises the resin composition according to any one of claims 1 to 7.

## Patentansprüche

1. Harzzusammensetzung, umfassend ein Epoxidharz (A), das durch die folgende allgemeine Formel (1) dargestellt ist, und eine Cyanatverbindung (B),

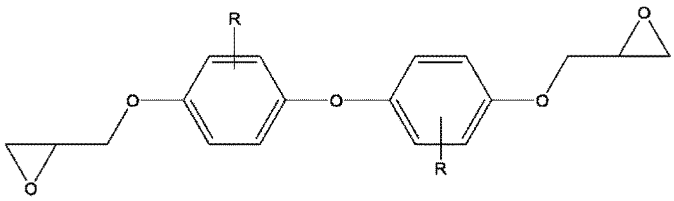

(1)

worin R jeweils unabhängig eine Alkylgruppe mit 1 bis 3 Kohlenstoffatomen oder ein Wasserstoffatom darstellt.

2. Harzzusammensetzung gemäß Anspruch 1, wobei ein Gehalt des Epoxidharzes (A) in der Harzzusammensetzung

1 bis 90 Masseteile, bezogen auf 100 Masseteile eines Harzfeststoffgehalts, beträgt.

3. Harzzusammensetzung gemäß Anspruch 1 oder 2, ferner umfassend ein/eine oder mehrere, ausgewählt aus der Gruppe, bestehend aus einem von dem Epoxidharz (A) verschiedenen Epoxidharz, einer Maleimidverbindung, einem Phenolharz, einem Oxetanharz, einer Benzoxazinverbindung und einer Verbindung mit einer polymerisierbaren ungesättigten Gruppe.

4. Harzzusammensetzung gemäß irgendeinem der Ansprüche 1 bis 3, wobei die Cyanatverbindung (B) eine oder mehrere, ausgewählt aus der Gruppe, bestehend aus einer Phenolnovolak-basierten Cyanatverbindung, einer Naphtholaralkyl-basierten Cyanatverbindung, einer Biphenylaralkyl-basierten Cyanatverbindung, einer Naphthylenether-basierten Cyanatverbindung, einer Xylolharz-basierten Cyanatverbindung, einer Adamantangerüst-basierten Cyanatverbindung und einer Cyanatverbindung, die eine Allylgruppe oder eine Propenylgruppe enthält, ist.

5. Harzzusammensetzung gemäß Anspruch 4, wobei die Cyanatverbindung (B) die Naphtholaralkyl-basierte Cyanatverbindung umfasst.

6. Harzzusammensetzung gemäß irgendeinem der Ansprüche 1 bis 5, ferner umfassend einen Füllstoff (C).

7. Harzzusammensetzung gemäß Anspruch 6, wobei ein Gehalt des Füllstoffs (C) in der Harzzusammensetzung 50 bis 1.600 Masseteile, bezogen auf 100 Masseteile des Harzfeststoffgehalts, beträgt.

8. Prepreg, umfassend ein Basismaterial und eine Harzzusammensetzung gemäß irgendeinem der Ansprüche 1 bis 7, mit der das Basismaterial imprägniert oder beschichtet ist.

9. Metallfolienkaschiertes Laminat, umfassend mindestens ein oder mehrere laminierte Prepregs gemäß Anspruch 8 und eine Metallfolie, die auf einer Oberfläche oder beiden Oberflächen des Prepregs angeordnet ist.

10. Harzfolie, umfassend die Harzzusammensetzung gemäß irgendeinem der Ansprüche 1 bis 7.

11. Gedruckte Verdrahtungsplatte, umfassend eine Isolierschicht und eine Leiterschicht, die auf einer Oberfläche der Isolierschicht gebildet ist, wobei die Isolierschicht die Harzzusammensetzung gemäß irgendeinem der Ansprüche 1 bis 7 umfasst.

## Revendications

1. Composition de résine comprenant une résine époxy (A) représentée par la formule générale (1) suivante ; et un composé de cyanate (B),

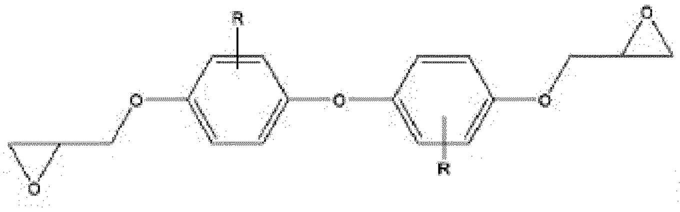

(1)

dans laquelle les R représentent chacun indépendamment un groupe alkyle ayant 1 à 3 atomes de carbone, ou un atome d'hydrogène.

2. Composition de résine selon la revendication 1, dans laquelle une teneur en résine époxy (A) dans la composition de résine est de 1 à 90 parties en masse sur la base de 100 parties en masse d'une teneur en solide de résine.

3. Composition de résine selon la revendication 1 ou 2, comprenant en outre un ou plusieurs sélectionnés dans le groupe constitué d'une résine époxy autre que la résine époxy (A), d'un composé de maléimide, d'une résine phénolique, d'une résine d'oxétane, d'un composé de benzoxazine, et d'un composé ayant un groupe insaturé polymérisable.

4. Composition de résine selon l'une quelconque des revendications 1 à 3, dans laquelle le composé de cyanate (B) est un ou plusieurs sélectionnés dans le groupe constitué d'un composé de cyanate à base de phénol novolaque, d'un composé de cyanate à base de naphtol aralkyle, d'un composé de cyanate à base de biphényl aralkyle, d'un composé de cyanate à base de naphtylène éther, d'un composé de cyanate à base de résine de xylène, d'un composé de cyanate à base d'un squelette d'adamantane, et d'un composé de cyanate contenant un groupe allyle ou un groupe propényle.

5. Composition de résine selon la revendication 4, dans laquelle le composé de cyanate (B) comprend le composé de cyanate à base de naphtol aralkyle.

6. Composition de résine selon l'une quelconque des revendications 1 à 5, comprenant en outre une charge (C).

7. Composition de résine selon la revendication 6, dans laquelle une teneur en charge (C) dans la composition de résine est de 50 à 1600 parties en masse sur la base de 100 parties en masse de la teneur en solide de résine.

8. Préimprégné comprenant un matériau de base ; et la composition de résine selon l'une quelconque des revendications 1 à 7 avec laquelle le matériau de base est imprégné ou enduit.

9. Stratifié recouvert d'une feuille métallique comprenant au moins un ou plusieurs des préimprégnés selon la revendication 8 stratifiés ; et une feuille métallique disposée sur une surface ou sur les deux surfaces du préimprégné.

10. Feuille de résine comprenant la composition de résine selon l'une quelconque des revendications 1 à 7.

11. Carte de circuit imprimé comprenant une couche isolante; et une couche conductrice formée sur une surface de la couche isolante, dans laquelle la couche isolante comprend la composition de résine selon l'une quelconque des revendications 1 à 7.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2009123058 A
- WO 2016062166 A
- WO 2014203866 A
- JP 2014185271 A
- JP 2017077757 A